# EUROPEAN PATENT APPLICATION

(11) **EP 4 471 932 A2**
(43) Date of publication of application: **04.12.2024**
(21) Application number: 24178998.1
(22) Date of filing: 30.05.2024
(51) Int. Cl.: H01M 10/42, H01M 50/284, H01M 50/296, H02J 7/00

(54) **BATTERY CABINET WITH BLIND MATE CONNECTORS**

(30) Priority: 30.05.2023 US 202363469725 P; 23.05.2024 US 202418672357
(71) Applicant: Vertiv Corporation, Westerville, OH 43082 (US)
(72) Inventor: MEYER, Adam, COLUMBUS, OH (US); DIXON, William M., LEWIS CENTER, OH (US)
(74) Representative: Kilburn & Strode LLP

(57) **Abstract**

The present disclosure relates to an energy management system including a cabinet including an opening configured to accept a battery management system (BMS) for controlling one or more batteries, where at least one of the batteries is located in the cabinet. The cabinet may further include a landing plate (LP) including one or more LP blind contacts configured to establish one or more electrical connections between the BMS and one or more electrical conductors in the cabinet when the BMS is inserted into an opening of the cabinet.

## Description

### TECHNICAL FIELD

The present disclosure relates generally to a battery management system (BMS) and, more particularly, to connections between a BMS system and a cabinet including one or more batteries.

### BACKGROUND

Market pressure continues to demand increased power and energy density for uninterruptible power supply (UPS) backup batteries, which in turn drives a demand for miniaturization of ancillary items such as the battery management system (BMS) and cable routing areas inside a cabinet. At the same time, it may be desirable to improve field operability of a BMS or other components. There is therefore a need to develop systems and methods to address these needs.

### SUMMARY

In a first aspect of the present disclosure, the techniques described herein relate to a system including a cabinet including an opening configured to accept a battery management system (BMS) for controlling one or more batteries; and a landing plate (LP) including one or more LP blind contacts configured to mate with one or more BMS blind contacts located on the BMS to establish one or more electrical connections between the BMS and one or more electrical conductors in the cabinet when the BMS is inserted into the opening.

In an example, the techniques described herein relate to a system, where the one or more electrical conductors are configured to connect to the one or more batteries, where the one or more batteries and the BMS are electrically connected when the BMS is inserted in the opening.

In an example, the techniques described herein relate to a system, where the LP further includes one or more terminals, where at least one of the one or more terminals is electrically connected to the one or more electrical conductors.

In an example, the techniques described herein relate to a system, where at least one of the one or more terminals is configured to provide electrical connections to an external system.

In an example, the techniques described herein relate to a system, where the external system includes at least one of a load, an electrical grid, or a power source.

In an example, the techniques described herein relate to a system, where the one or more terminals are on an opposite side of the LP than at least one of the one or more LP blind contacts.

In an example, the techniques described herein relate to a system, where the system includes an uninterruptible power supply (UPS).

In an example, the techniques described herein relate to a system, where the one or more LP blind contacts and the one or more corresponding BMS blind contacts form one or more blind mate connectors.

In an example, the techniques described herein relate to a system, where the one or more LP blind contacts include one or more male connectors, where the one or more BMS blind contacts include one or more female connectors.

In an example, the techniques described herein relate to a system, where at least one of the one or more male connectors includes a metal busbar, where a corresponding one of the one or more female connectors includes a clamp.

In an example, the techniques described herein relate to a system, where the one or more LP blind contacts include one or more female connectors, where the one or more BMS blind contacts include one or more male connectors.

In an example, the techniques described herein relate to a system, where at least one of the one or more male connectors includes a metal busbar, where a corresponding one of the one or more female connectors includes a clamp.

In an example, the techniques described herein relate to a system, where at least one of the BMS or the cabinet includes one or more guiding features to align the one or more BMS blind contacts to the one or more LP blind contacts when the BMS is inserted into the opening of the cabinet.

In an example, the techniques described herein relate to a battery management system (BMS) including a housing; and one or more BMS blind contacts attached to the housing configured to mate with one or more landing pate (LP) blind contacts located on an LP of a cabinet to establish one or more electrical connections between the BMS and one or more electrical conductors in the cabinet when the BMS is inserted into an opening of the cabinet.

In an example, the techniques described herein relate to a BMS, where the one or more electrical conductors are configured to connect to one or more batteries, where the one or more batteries and the BMS are electrically connected when the BMS is inserted in the opening.

In an example, the techniques described herein relate to a BMS, where the one or more LP blind contacts and the corresponding BMS blind contacts form one or more blind mate connectors.

In an example, the techniques described herein relate to a BMS, where the one or more LP blind contacts include one or more male connectors, where the one or more BMS blind contacts include one or more female connectors.

In an example, the techniques described herein relate to a BMS, where the one or more LP blind contacts include one or more female connectors, where the one or more BMS blind contacts include one or more male connectors.

In an example, the techniques described herein relate to a BMS, where at least one of the BMS or the cabinet includes one or more guiding features to align the one or more BMS blind contacts to the one or more LP blind contacts when the BMS is inserted into the opening of the cabinet.

In an example, the techniques described herein relate to a BMS, further including a controller including one or more processors configured to execute program instructions stored in a memory device, where the program instructions are configured to cause the one or more processors to at least one of monitor or control the one or more batteries.

It is to be understood that both the foregoing general description and the following detailed description are exemplary and explanatory only and are not necessarily restrictive of the invention as claimed. The accompanying drawings, which are incorporated in and constitute a part of the specification, illustrate examples of the invention and together with the general description, serve to explain the principles of the invention.

### BRIEF DESCRIPTION OF DRAWINGS

The numerous advantages of the disclosure may be better understood by those skilled in the art by reference to the accompanying figures.
FIG. 1 is a block diagram of an energy management system, in accordance with one or more examples of the present disclosure.
FIG. 2A is a perspective view of a cabinet and a battery management system (BMS) prior to insertion of the BMS into the cabinet, in accordance with one or more examples of the present disclosure.
FIG. 2B is a perspective view of a cabinet and a BMS after insertion of the BMS into the cabinet in which a blind mate electrical connection is established, in accordance with one or more examples of the present disclosure.
FIG. 2C is a perspective cross-sectional view of the BMS and a landing plate (LP) illustrating the blind mate electrical connection, in accordance with one or more examples of the present disclosure.
FIG. 3 is a perspective view of a backside of the cabinet illustrating terminals for connecting the LP to additional components, in accordance with one or more examples of the present disclosure.

### DETAILED DESCRIPTION

Reference will now be made in detail to the subject matter disclosed, which is illustrated in the accompanying drawings. The present disclosure has been particularly shown and described with respect to certain examples and specific features thereof. The examples set forth herein are taken to be illustrative rather than limiting. It should be readily apparent to those of ordinary skill in the art that various changes and modifications in form and detail may be made without departing from the spirit and scope of the disclosure.

Examples of the present disclosure are directed to systems and methods providing a blind mate electrical connection between a battery management system (BMS) and a cabinet, which may secure the BMS as well as batteries to be connected to the BMS.

In some examples, an energy management system includes a cabinet with an opening to receive (e.g., accept) a BMS and a landing plate configured to receive the BMS when inserted into the opening. The landing plate (LP) and the BMS may be electrically connected using one or more blind mate couplers when the BMS is inserted into the opening. For example, the LP may include LP blind contacts configured to couple with corresponding BMS blind contacts on a BMS when the BMS is inserted within a cabinet. In this way, an LP blind contact and a BMS blind contact may form a blind mate coupler suitable for providing a blind mate electrical connection. The landing plate may further include one or more terminals to provide electrical connections to one or more batteries to be managed by the BMS.

As used herein, a blind mate connection or blind mate coupling refers to electrical coupling and decoupling between an enclosure (here, a cabinet) and an insertable module (here, a BMS) upon insertion and removal of the module, respectively, without the use of mechanical fasteners specific to the electrical connection. In contrast, typical electrical connectors include or require a mechanical fastener to secure an electrical connection such as, but not limited to, a threaded connector, a nut-and-bolt connector, a retention tab (e.g., a locking tab), or the like. In a blind mate connection, the electrical connection may be secured if necessary by fastening the module to the enclosure.

The systems and methods disclosed herein may provide various benefits for an energy management system. For example, a blind mate electrical connection between a BMS and a cabinet may facilitate easy removal of the BMS as necessary for repairs, replacement, or the like. As another example, a landing plate within the cabinet providing both LP blind contacts for the blind mate connection to the BMS as well as terminals for electrical connections to one or more batteries may facilitate convenient power connections for the batteries in a compact form factor that minimizes volume, part count, and cost.

As an illustration, typical systems utilize traditional mechanically-fastened electrical connects between the BMS and batteries, which often requires a separate conduit box to operate as a coupler between the BMS and the batteries. Such a configuration further requires a design that provides access to such electrical connections to the BMS and requires effort during servicing to disconnect and then reconnect the BMS. In contrast, the systems and methods disclosed herein provide a robust landing area for the batteries, which may conveniently receive large cables or busbars from a rigid conduit in a space-efficient manner, and which may also facilitate easy servicing of the BMS through the blind mate connection. As a result, the systems and methods disclosed herein may provide high energy and power density (e.g., performance per unit of cost) in a small form factor as well as convenient installation and servicing of all components.

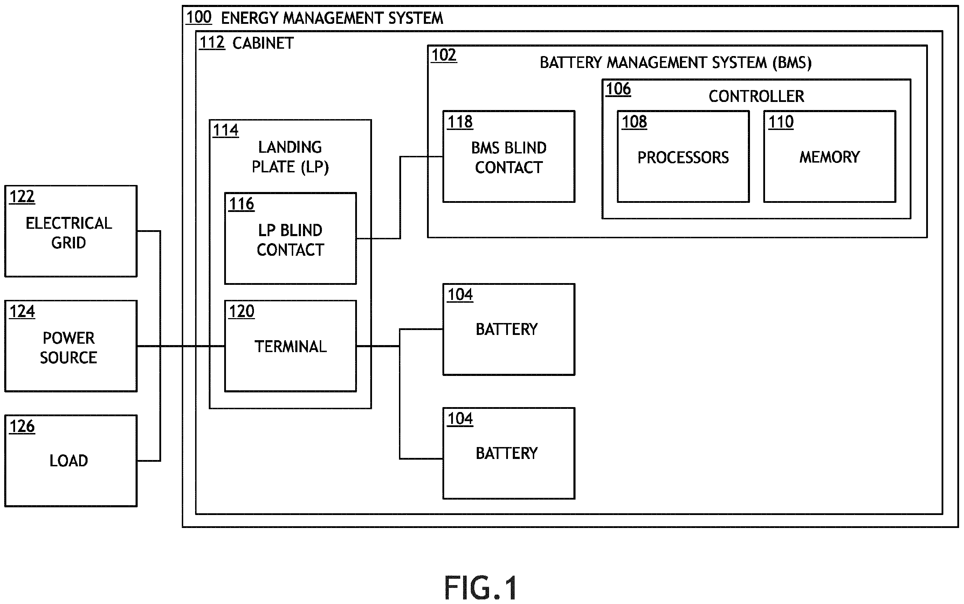

Referring now to FIGS. 1-3, systems and methods for blind mate connections to a BMS are described in greater detail, in accordance with one or more examples of the present disclosure.

FIG. 1 is a block diagram of an energy management system 100, in accordance with one or more examples of the present disclosure.

The energy management system 100 includes a battery management system (BMS) 102 connected to one or more batteries 104. The energy management system 100 included any number or type of batteries 104 such as, but not limited to, lithium-ion, nickelcadmium, or lead acid. Further, a battery 104 may be formed as a single unit or as multiple units connected in either series or parallel. For example, a battery 104 may be formed as a rack of battery sub-units.

The batteries 104 include components to perform various functions such as, but not limited to, monitoring, control, or communications. For example, a battery 104 may include one or more sensors to monitor properties such as, but not limited to, charge, a charging state, a voltage, incoming or outgoing current, temperature, or predicted lifespan. As another example, a battery 104 may include charging circuitry to control charge/discharge rates, circuity to prevent over-voltage, over-current, or over-temperature conditions, or the like.

The BMS 102 includes any type of battery management or control system known in the art and may perform a variety of operations. A BMS 102 includes one or more sensors configured and/or monitoring circuitry to monitor various aspects of any of the batteries 104 including, but not limited to, a charge, a charging state, a voltage, incoming or outgoing current, temperature, or predicted lifespan. The BMS 102 includes any type of sensor known in the art including, but not limited to, a current sensor, a voltage sensor, or a temperature sensor. The BMS 102 includes a controller 106 with one or more processors 108 configured to execute program instructions maintained on a memory 110

(e.g., memory medium). The program instructions causes the processors 108 of the controller 106 to perform various functions directly or indirectly (e.g., by generating control signals). As an illustration, the program instructions cause the processors 108 to perform functions associated with the monitoring and/or management of one or more connected batteries 104. For example, the controller 106 may perform various control functions such as, but not limited to, load balancing between batteries 104, charging control, over-voltage protection, over-current protection, or over-heating protection. The BMS 102 includes communications circuitry to communicate with additional systems, such as, but not limited to, an external control system, an additional BMS 102, the batteries 104, or the like. For example, the BMS 102 may receive power supply data associated with available power or predicted power availability, load data associated with current or predicted load conditions, data from any of the batteries 104, or the like.

The one or more processors 108 of a controller 106 includes any processing element known in the art. In this sense, the one or more processors 108 includes any microprocessor-type device configured to execute algorithms and/or instructions. For example, the processors 108 may include one or more central processing units (CPUs), graphical processing units (GPUs), digital signal processors (DSPs), field-programmable gate arrays (FPGAs), or application-specific integrated circuits (ASICs).

The memory 110 includes any storage medium known in the art suitable for storing program instructions executable by the associated one or more processors 108. For example, the memory 110 may include a non-transitory memory medium. By way of another example, the memory 110 may include, but is not limited to, a read-only memory (ROM), a random-access memory (RAM), a magnetic or optical memory device (e.g., disk), a magnetic tape, a solid-state drive, and the like.

The energy management system 100 includes one or more cabinets 112 to secure and/or house various components such as, but not limited to, the BMS 102 or any of the batteries 104. For example, a cabinet 112 may be a rack system including various openings, platforms, rails, guides, or the like suitable for housing the various components. As will be described in greater detail below, a cabinet 112 may further include components suitable for providing electrical connections with or between any installed components.

The cabinet 112 includes a landing plate (LP) 114 providing a blind mate connection to a BMS 102 installed within the cabinet 112. For example, an LP 114 may include at least one LP blind contact 116 configured to provide a blind mate connection with a corresponding BMS blind contact 118 located on the BMS 102. In this way, an LP blind contact 116 and a BMS blind contact 118 may together form a blind mate connector. In a general sense, the LP 114 and the BMS 102 may include any number of LP blind contacts 116 and BMS blind contacts 118, respectively, to provide any number or type of electrical connections. For example, the LP blind contacts 116 and the BMS blind contacts 118 may provide any number of hot connections, neutral connections, ground connections, or the like. Further, the LP blind contacts 116 and the BMS blind contacts 118 may provide any combination of direct current (DC) power transfer, alternating current (AC) power transfer, or communications in uni-directional or bi-directional configurations.

The LP 114 further includes one or more terminals 120, at least some of which are electrically connected to the LP blind contacts 116. In a general sense, the terminals 120 provide electrical connections between various components within the energy management system 100 and/or to external systems. For example, the terminals 120 may provide connections to the batteries 104 to be managed by the BMS 102. As another example, the terminals 120 may provide connections to external systems such as, but not limited to, an electrical grid 122, a power source 124 (e.g., solar energy source, a wind energy source, or the like), or a load 126.

The energy management system 100 provides a variety of different functions, which may be managed at least in part by the BMS 102.,The energy management system 100 operates as an uninterruptible power supply (UPS). In this configuration, the load 126 may be powered by any combination of a grid 122 or a power source 124 under typical conditions, but may be powered by the batteries 104 when the grid 122 and/or the power source 124 have insufficient power supply. Further, the batteries 104 may be charged by the grid 122 and/or the power source 124 and/or may provide power back to the grid 122 and/or the power source 124.

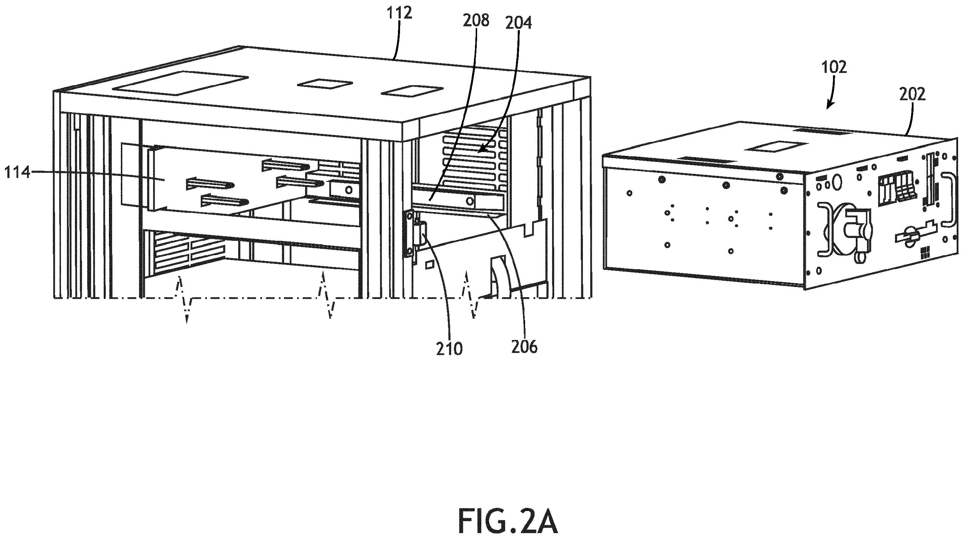

Referring now to FIGS. 2A-3, connections between the LP 114, the BMS 102, and the batteries 104 are described in greater detail, in accordance with one or more examples of the present disclosure.

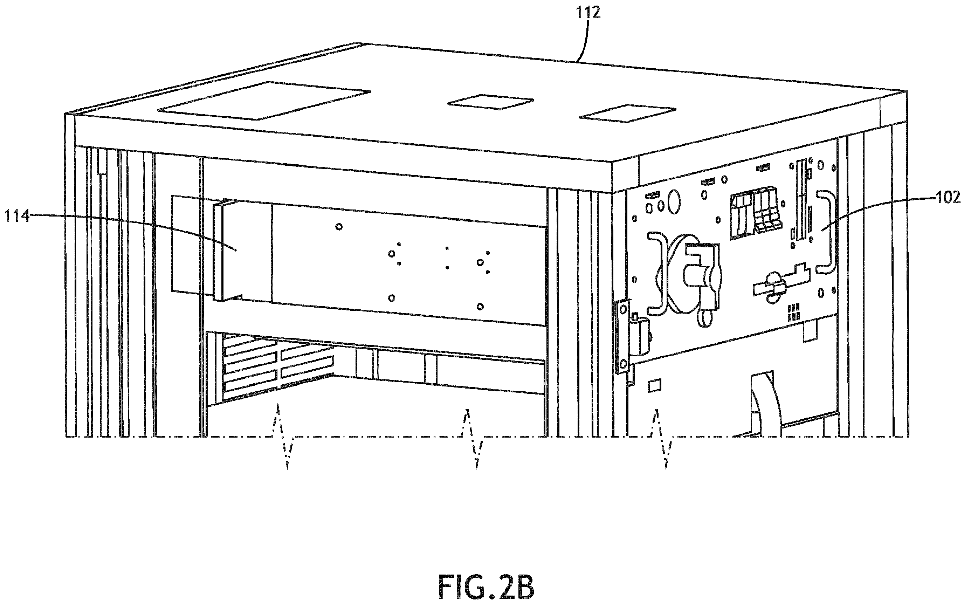

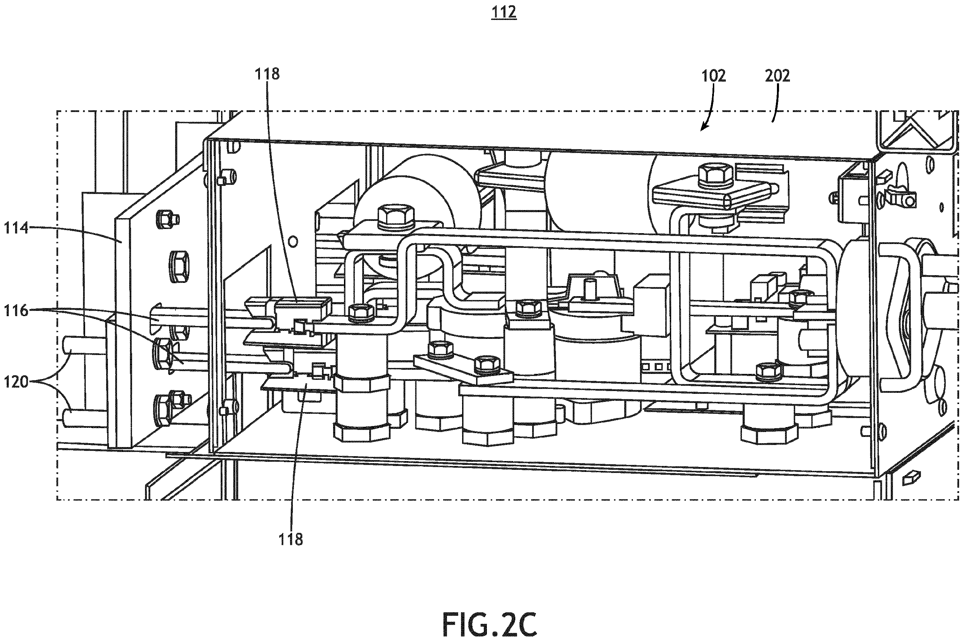

FIGS. 2A-2C depict installation of a BMS 102 into a cabinet 112 to establish a blind mate electrical connection, in accordance with one or more examples of the present disclosure. FIG. 2A is a perspective view of a cabinet 112 and a BMS 102 prior to insertion of the BMS 102 into the cabinet 112, in accordance with one or more examples of the present disclosure. FIG. 2B is a perspective view of a cabinet 112 and a BMS 102 after insertion of the BMS 102 into the cabinet 112 in which a blind mate electrical connection is established, in accordance with one or more examples of the present disclosure. FIG. 2C is a perspective cross-sectional view of the BMS 102 and the LP 114 illustrating the blind mate electrical connection, in accordance with one or more examples of the present disclosure.

In FIGS. 2A-2C, a BMS 102 is shown with a housing 202 sized to fit within an opening 204 of the cabinet 112. Further, the cabinet 112 may include various features to receive and/or position the BMS 102 within the such as, but not limited to, a platform 206, guides 208, or the like.

FIGS. 2A-2C further depict a LP 114 in a rear portion of the opening 204 formed as a mechanically rigid material suitable for supporting LP blind contacts 116 for connecting to the BMS 102 and terminals 120 for connecting to additional components such as, but not limited to, the batteries 104. The LP 114 is formed from a non-conductive material. In this way, the terminals 120 and the LP blind contacts 116 may be electrically connected via conductors. In some examples, the LP 114 is formed from a conductive material. In this configuration, various non-conductive materials may be used to insulate any electrical connections.

The blind mate connectors formed from the LP blind contacts 116 and the BMS blind contacts 118 may be formed as any type of blind mate connector known in the art. For example, many blind mate connectors include a male connector and a female connector, which may connect through a sliding interlock, a snapping interlock, or the like, though this is not a requirement. A blind mate connector may be configured to provide a single electrical connection or multiple electrical connections. In the case of multiple electrical connections, these connections may be made simultaneously or sequentially. As an illustration, a male portion of a blind mate connector may include multiple contacts (e.g., pins, busbars, or the like) of different lengths to provide sequential connections. As another illustration, a female portion of a blind mate connector may include multiple contacts recessed at different depths to provide sequential connections. Further, any of the various contacts may be shielded or unshielded.

It is contemplated herein that any of the LP blind contacts 116 or the BMS blind contacts 118 may be male or female. Further, the BMS 102 and the LP 114 may utilize blind mate connectors of a single design or multiple designs.

As an illustration, FIGS. 2A-2C depict a configuration in which the LP blind contacts 116 are formed as busbars (e.g., male connectors) while the BMS blind contacts 118 are formed as clamps (e.g., female connectors). The busbars are metal busbars. In this configuration, the busbars may slide into and out of the clamps to establish an electrical connection and may slide out of the clamps for disconnection. Further, the clamps may include or be formed from a spring to provide a stable electrical connection while still facilitating coupling and decoupling.

Alignment between the LP blind contacts 116 and the BMS blind contact 118 during insertion of the BMS 102 into the cabinet 112 may be achieved through a variety of techniques. The LP 114 and/or the BMS 102 include keyed or guiding features near any of the associated contacts to ensure alignment at locations near any of the contacts. For example, the guides 208 and/or the platform 206 of the cabinet 112 in FIGS. 2A-2C may be guiding features that position the BMS 102 with respect to the LP 114 with sufficient accuracy to provide a reliable connection between the LP blind contacts 116 and the BMS blind contacts 118. In some cases, keyed and/or guiding features only allow insertion of the BMS 102 in a selected orientation that ensures alignment of the LP blind contacts 116 and the BMS blind contact 118. As another example, the shape of the opening 204 itself may provide sufficient alignment of the LP blind contacts 116 and the BMS blind contact 118. However, this is merely and illustration and should not be interpreted as limiting the scope of the present disclosure.

The electrical connection between the BMS 102 and the LP 114 is secured using any suitable technique. The BMS 102 is mechanically secured to the cabinet 112 in a way sufficient to prevent unintentional disconnections between the LP blind contacts 116 and the BMS blind contacts 118. For example, FIG. 2A depicts a latch 210 on the cabinet 112 to mechanically secure the BMS 102. In some examples, the BMS 102 and/or the LP 114 includes components to snap together when the BMS 102 is fully installed such that the BMS 102 may only be removed by applying a force sufficient to unsnap these components.

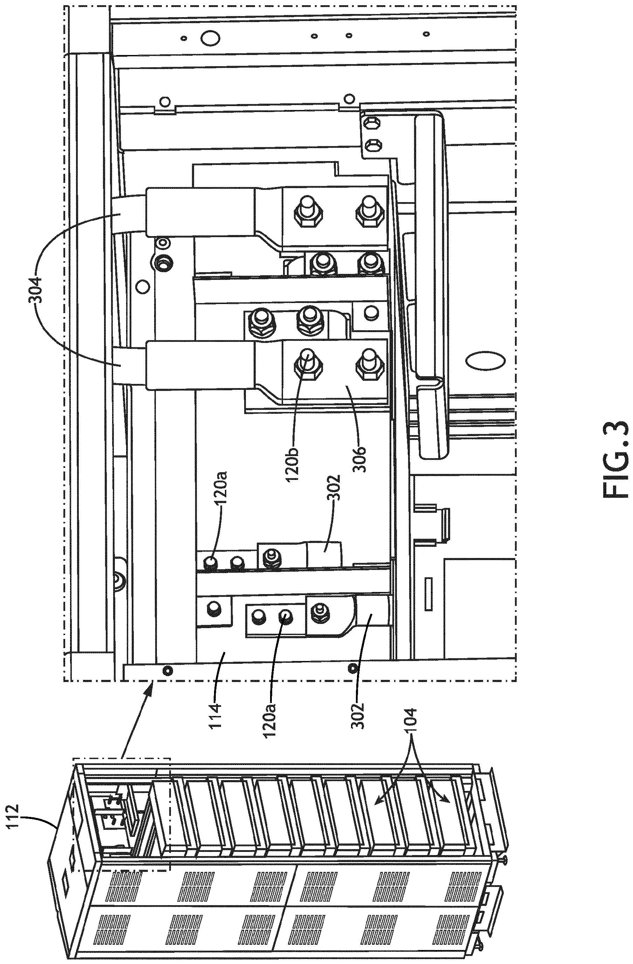

FIG. 3 is a perspective view of a backside of the cabinet illustrating terminals 120 for connecting the LP 114 to additional components, in accordance with one or more examples of the present disclosure. For example, the terminals 120 may provide electrical connections to the batteries 104, a grid 122, a power source 124, or the like as depicted in FIG. 1.

As an illustration, FIG. 3 depicts a first set of terminals 120a connected to a first set of power cables 302 providing to connections to batteries 104 within the cabinet 112. FIG. 3 further depicts a second set of terminals 120b connected to a second set of cables 304 providing connections to components outside the cabinet 112 (e.g., the grid 122 and/or power source 124 as depicted in FIG. 1).

The terminals 120 include any sort of electrical connectors known in the art. In some examples, a terminal 120 is a blind connector suitable for providing a blind mate connection with another component. For example, the batteries 104 may be designed to provide blind mate connections to the LP 114 in a manner similar to that described for the BMS 102. A terminal 120 is a typical connector providing a mechanically-fastened connection. For example, FIG. 3 illustrates a configuration in which the terminal 120 includes a threaded bolt onto which a conductive plate 306 from a cable 304 may be secured with a nut. Such a configuration may provide a convenient connection to widely available cables, which may increase ease of use and reduce cost and complexity. However, it is to be understood that any of the terminals 120 may utilize any type of electrical connection technique known in the art. Further, the terminals 120 may include any combination of male or female connector components.

Referring generally to FIGS. 2A-3, it is to be understood that FIGS. 2A-3 are provided solely for illustrative purposes and should not be interpreted as limiting. For example, a cabinet 112 may include any number of LPs 114 located at any location suitable for making an electrical connection with the BMS 102. For example, a cabinet 112 may include an LP 114 on a side of the opening 204 to make blind mate connections with BMS blind contacts 118 on a corresponding side of the housing 202The BMS blind contacts 118 are attached to the housing 202. As another example, various terminals 120 may be located at any location of the LP 114 and thus may be located on the same face as the LP blind contacts 116 or an opposite face from the LP blind contacts 116 (e.g., as depicted in FIGS. 2A-3).

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

## Claims

1. A system comprising:
a cabinet including an opening configured to accept a battery management system (BMS) for controlling one or more batteries; and
a landing plate (LP) including one or more LP blind contacts configured to mate with one or more BMS blind contacts located on the BMS to establish one or more electrical connections between the BMS and one or more electrical conductors in the cabinet when the BMS is inserted into the opening.

2. The system of claim 1, wherein the one or more electrical conductors are configured to connect to the one or more batteries, wherein the one or more batteries and the BMS are electrically connected when the BMS is inserted in the opening.

3. The system of claim 1, wherein the LP further includes one or more terminals, wherein at least one of the one or more terminals is electrically connected to the one or more electrical conductors.

4. The system of claim 3, wherein at least one of the one or more terminals is configured to provide electrical connections to an external system, and preferably, wherein the external system comprises:
at least one of a load, an electrical grid, or a power source.

5. The system of claim 3, wherein the one or more terminals are on an opposite side of the LP than at least one of the one or more LP blind contacts.

6. The system of claim 1, wherein the system comprises an uninterruptible power supply (UPS).

7. The system of claim 1, wherein the one or more LP blind contacts and the one or more BMS blind contacts form one or more blind mate connectors, and/or wherein the one or more LP blind contacts include one or more male connectors, wherein the one or more BMS blind contacts include one or more female connectors, and wherein preferably a corresponding one of the one or more female connectors comprises a clamp, and/or wherein the one or more LP blind contacts include one or more female connectors, wherein the one or more BMS blind contacts include one or more male connectors, and wherein preferably . at least one of the one or more male connectors comprises a metal busbar, wherein a corresponding one of the one or more female connectors comprises a clamp.

8. The system of claim 1, wherein at least one of the BMS or the cabinet includes one or more guiding features to align the one or more BMS blind contacts to the one or more LP blind contacts when the BMS is inserted into the opening of the cabinet.

9. A battery management system (BMS) comprising:
a housing; and
one or more BMS blind contacts attached to the housing configured to mate with one or more landing plate (LP) blind contacts located on an LP of a cabinet to establish one or more electrical connections between the BMS and one or more electrical conductors in the cabinet when the BMS is inserted into an opening of the cabinet.

10. The BMS of claim 9, wherein the one or more electrical conductors are configured to connect to one or more batteries, wherein the one or more batteries and the BMS are electrically connected when the BMS is inserted in the opening.

11. The BMS of claim 9, wherein the one or more LP blind contacts and the one or more BMS blind contacts form one or more blind mate connectors.

12. The BMS of claim 9, wherein the one or more LP blind contacts include one or more male connectors, wherein the one or more BMS blind contacts include one or more female connectors.

13. The BMS of claim 9, wherein the one or more LP blind contacts include one or more female connectors, wherein the one or more BMS blind contacts include one or more male connectors.

14. The BMS of claim 9, wherein at least one of the BMS or the cabinet includes one or more guiding features to align the one or more BMS blind contacts to the one or more LP blind contacts when the BMS is inserted into the opening of the cabinet.

15. The BMS of claim 9, further comprising:
a controller including one or more processors configured to execute program instructions stored in a memory device, wherein the program instructions are configured to cause the one or more processors to at least one of monitor or control the one or more batteries.
